# EUROPEAN PATENT APPLICATION

(11) **EP 2 733 759 A1**
(43) Date of publication of application: **21.05.2014**
(21) Application number: 13005211.1
(22) Date of filing: 05.11.2013
(51) Int. Cl.: H01L 51/00, H05K 1/18, H05K 1/09, C09D 5/24, C23C 18/08, F21V 23/00, C09D 11/00

(54) **Multi-layer composite with metal-organic layer**

(30) Priority: 15.11.2012 EP 12007746; 17.09.2013 EP 13004525
(71) Applicant: Heraeus Precious Metals GmbH & Co. KG, 63450 Hanau (DE); Korea Electronics Technology Institute, Gyeonggi-do 463-816 (KR)
(72) Inventor: Fuchs, Herbert, 63549 Ronneburg (DE); Ha, Hyung Seok, 152-89 Seoul (KR); Timter, Kerstin, 63607 Wächtersbach / Aufenau (DE); Lee, Jeongno, Gyeonggi-do 449-753 (KR); Lee, Bumjoo, Gyeonggi-do 463-730 (KR); Han, Chul Jong, Seoul 135-942 (KR); Lee, Seunghyun, Jeollabuk-do (KR)
(74) Representative: Herzog, Martin

(57) **Abstract**

A multi-layer composite precursor (2) is provided comprising:
i. a substrate (4), wherein the substrate (4) comprises:
1. a light emitting organic compound;
2. a first surface (8); and
3. a second surface (10),

wherein the second surface (10) is superimposed by a transparent electrically conducting layer (12),
ii. a liquid phase (18) superimposing at least a part of the first surface (8) comprising a metal-organic compound, wherein the metal-organic compound comprises an organic moiety, wherein the organic moiety comprises a C=O group; and wherein the liquid phase (18) further comprises a first silicon compound, wherein the first silicon compound comprises at least one carbon atom and at least one nitrogen atom.

## Description

The invention relates to a multi-layer composite precursor comprising a substrate superimposed by a liquid layer comprising a metal-organic compound and a silicon compound, to a method for the manufacture of a multi-layer composite, to a composite obtained by this method and to a multi-layer composite with specific properties.

The application of metal layers in the form of coatings in electronic components is well known in the prior art. For example, the electronics, display and energy industries rely on the formation of coatings and patterns of conductive materials to form circuits on organic and inorganic substrates. The primary methods for generating these patterns are screen printing for features larger than about 100 µm and thin film and etching methods for features having a feature size not greater than about 100 µm. In the document US 6 951 666 B2 a screen printing method is used to deposit a precursor composition onto a substrate and then form an electrically conductive line out of the precursor composition. The precursor composition comprises a silver and/or copper metal for the formation of conductive features. After deposition of the precursor composition onto the substrate the substrate is heated to form a conductive metal layer.

US 6 951 666 B2 utilizes mainly fluorinated silver compounds or silver acetate compounds for the building of the metal layer which are deposited together with additives onto the surface of a substrate. The metal compound and the additives are heated together to form the metal layer on the substrate. The additives are chosen in such a way as to decrease the temperature when the metal compound converts to substantially pure metal.

To create a stable metal surface with a good adhesion to the substrate it has been observed, however, that using fluorinated silver compounds or silver acetate together with additives for decreasing the temperature of the metal conversion as described in the examples of US 6 951 666 B2 has some drawbacks. The fluorinated silver compounds, for example, produce hydrogen fluoride during heating which can destroy its surroundings, especially the substrate. The silver acetate on the other hand is very light-sensitive. Thus a stable metal layer could not be achieved in a reproducible and cost efficient way. Furthermore, the adhesion of the silver compounds needs to be improved.

An object of the invention is thus to reduce or even overcome at least one of the disadvantages of the state of the art.

In particular, it is an object of the invention to provide a multi-layer composite precursor that shows all components for the generation of a stable and sophisticated composite, especially for use in electronic compounds. In particular, it is an object of the invention to provide a multi-layer composite precursor that can easily be converted into a multi-layer composite with improved properties, especially improved electrical properties and improved stability.

Additionally, it is an object of the invention to provide a composite or a multi-layer composite that shows electrically conductive layers with improved properties, especially with reduced size, reduced surface roughness, reduced surface resistance, reduced crystal-size or improved transparency.

A further object of the invention is to provide a composite or a multi-layer composite with enhanced adhesion of the metal layer to the substrate.

Furthermore, it is an object of the invention to provide a composite or a multi-layer composite with improved surface properties, especially with a more even surface of the metal layer.

Additionally, it is an object of the invention to provide a composite or a multi-layer composite with enhanced antistatic properties of its surface.

It is furthermore an object of the invention to provide a simplified process for the manufacture of a composite.

Moreover, it is an object of the invention to provide a cost effective process for the manufacture of a composite.

It is also an object of the invention to provide a composite with advantageous properties for application in the electronics field, especially in the preparation of electronic components like OLEDs, transistors or touch screens. Especially, the antistatic properties of the electronic components are to be enhanced.

It is further an object of the invention to provide an electronic component with improved features, especially with electrically conductive layers that show a good stability and a good electrical conductivity.

A contribution to the solution of at least one of the above objects is provided by the subject matter of the category-forming independent claims, wherein the therefrom dependent sub-claims represent preferred embodiments of the present invention, whose subject matter likewise make a contribution to solving at least one object.

The invention relates to
a multi-layer composite precursor comprising:
i. a substrate, wherein the substrate comprises
   1. a light emitting organic compound,
   2. a first surface and
   3. a second surface,
   wherein the second surface is superimposed by a transparent electrically conducting layer,
ii. a liquid phase superimposing at least a part of the first surface comprising a metal-organic compound, wherein the metal-organic compound comprises an organic moiety, wherein the organic moiety comprises a C=O group; and wherein the liquid phase further comprises a first silicon compound, wherein the first silicon compound comprises at least one carbon atom and at least one nitrogen atom.

According to one preferred embodiment of the invention, the light emitting organic compound is an organic molecule which does not have polymeric structure, i.e. which does not contain three, preferably five, or more repeating units. Such organic molecules are preferably selected from the group consisting of compounds according to formula (I) to (V): 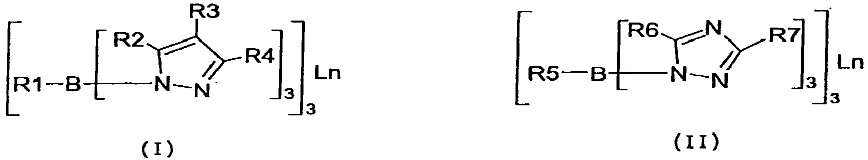 wherein
Ln stands for Ce³⁺, Ce⁴⁺, Pr³⁺, Pr⁴⁺, Nd³⁺, Nd⁴⁺, Pm³⁺, Sm³⁺, Sm²⁺, Eu³⁺, Eu²⁺, Gd³⁺, Tb³⁺, Tb⁴⁺, Dy³⁺, Dy⁴⁺, Ho³⁺, Er³⁺, Tm³⁺, Tm²⁺, Yb³⁺, Yb²⁺ or Lu³⁺,
R₁ stands for pyrazolyl-, triazolyl-, heteroaryl-, alkyl-, aryl-, alkoxy-, phenolat- or amid-group, which can be substituted or unsubstituted,
or
R₅ stands for R₁ or H, and
R₂, R₃, R₄, R₆, R₇ stands for H, a halogen or a hydrocarbon, which can comprise a hetero atom, particularly a alkyl-, aryl- group or heteroaryl.
To diminish the volatility of formula (I) or (II), the compounds R₂ to R₇ can be fluorinated.

Additionally or alternatively the organic compound can comprise a compound according to formula (III)

(NC)ₙM(CNR)ₘ (III)

whererin
M stands for Pt(II), Rh(I), Ir(I), Pd(II) or Au(III), particularly Pt(II) or Pd(II),
R stands for hydrocarbon group, which can comprise at least one hetero atom,
n = 0 to 4
and
m = 0 to 4.
Preferably, m = 4 - n 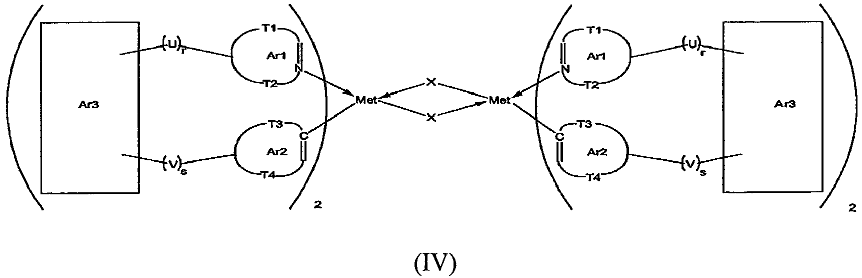
or 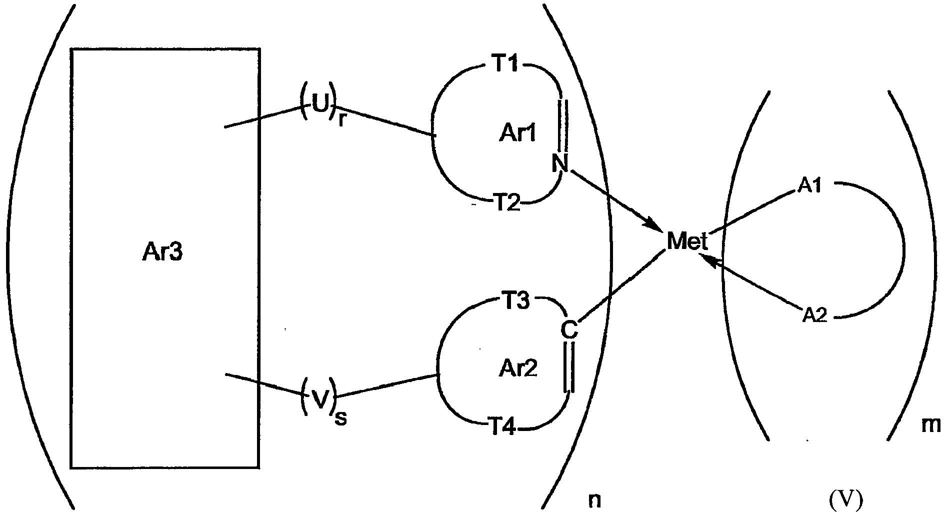
wherein Met stands for Ir, Pt, Pd, Ru, Rh, Re or OS with n = 1-3, m= 3-n for Ir, Ru, Rh, Re or OS and with n = 1 or 2, m = 2-n for Pt or Pd,
wherein r and s are independently positive natural numbers from 0 to 8, preferably 1 to 5, preferably varying by a maximum of 2, more preferably identical,
wherein groups U and V can be selected independently from a chemical bond, any substituted or unsubstituted aromatic or non-aromatic poly- or mono-cyclic group, alkyl, -CR'=CR"-, -C≡C-, nitrogen, oxygen, sulfur, selenium, telluride, NR with R, R' and R" independently selected from hydrogen, (hetero)alkyl and (hetero)aryl,
wherein Ar3 is an aromatic or non-aromatic moiety which allows the formation of chemical bonds to groups U and V, respectively, and
wherein T1 and T4 can independently be selected from -O-, -S-, NR-, -CRR'-, =CR-, =N-, -N=N-, =N-O-, -O-N=, -NR-O-, -O-NR-, =N-S-, -S-N=, -NR-S-, -S-NR-, -N=CR-, -CR=N, -NR-CR'R"-, -CR'R"-NR-, =N-CRR'-, CRR'N=, -CR=CR'- with R and R' and R" independently selected from hydrogen, (hetero)alkyl, and (hetero)aryl. The substituents R, R' and R" can also be connected in a way that a fused ring system results.

Saturating ligand 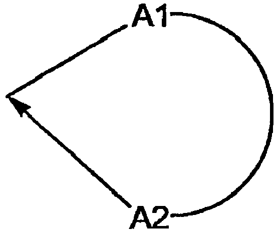 is a monoanionic ligand, preferably selected from the group comprising acetylacetonate or its derivatives, 2-pyridylacetate (also termed picolinate) or its derivatives, dipivaloylmethanate or its derivatives, 2-pyridylfomiate or its derivatives, 2-(4H-[1,2,4]triazol-3-yl)pyridine or its derivatives. Saturating ligands of specified and exemplary compounds can be exchanged for one another, even if one specific saturating ligand is indicated.

According to another preferred embodiment of the invention, the light emitting organic compound is a polymer which contains three or more repeating units. These units are quite often derived from the monomers used for making the polymer. The light emitting polymer may comprise light emitting moieties as described by formula (I) to (V) either in dissolved or dispersed form or as a group attached to the polymer by chemical and/or physical bonds.

The multi-layer composite precursor according to the invention comprises a substrate that the person skilled in the art would consider suitable for use in the context of the present invention. The substrate is preferably of a material that enables the substrate to be superimposed by at least one further material, preferably in form of a layer. Preferably, the substrate is a solid. It is preferable for the substrate to be flexible. The material of the substrate is preferably selected from the group consisting of a glass, a polymer, a ceramic, a paper, a metal oxide and a metal or a combination of at least two thereof. Preferably, the material of the substrate comprises a polymer or glass. The glass is preferably selected from the group consisting of soda-lime glass, lead alkali glass, borosilicate glass, aluminosilicate glass, fused silica, non alkaline glass or mixtures of at least two thereof. The polymer is preferably selected from the group consisting of a polyethylene, a polypropylene, a polystyrene, a polyimide, a polycarbonate and a polyester or a combination of at least two thereof. Preferably, the polymer is selected from the group of a poly (ethylene therephthalate), polyethylene naphthalate, polybismaleinimid (PBMI), polyben-zimidazol (PBI), polyoxadiazobenzimidazol (PBO), polyimidsulfon (PISO) and polymethacrylimid (PMI) or a mixture of at least two thereof. It is preferred that the substrate comprises a polymer in a range of 10 to 100 wt.-%, or preferably in a range of from 20 to 95 wt.-%, or preferably in a range of from 30 to 90 wt.-%. The substrate can have any form or geometry that is suitable for use in a multi-layer composite precursor. The substrate preferably has the form or geometry of a layer. The thickness of the substrate preferably lies in a range of from 0.1 to 1000 µm, more preferably in a range of from 1 to 500 µm, or preferably in a range of from 1 to 100 µm. The substrate preferably has an areal extension, defined as the product of the width and the length, in a range of from 0.01 mm² to 1 000 000 cm², or preferably in a range of from 0.1 mm² to 500 000 cm², or preferably in a range of from 1 mm² to 100 000 cm². According to the invention, the substrate comprises a first and a second surface. The first and the second surface of the substrate are preferably provided on the areal extension of the substrate. Preferably, the two surfaces are on opposite sides of the substrate, which is particularly preferred if the substrate is a layered structure, such as a plate, a disc or a bar.

The substrate comprises a light emitting organic compound according to the invention. The formulation that the substrate comprises a light emitting organic compound can either mean that the light emitting organic compound is part of the substrate or in form of two individual layers. These two layers can be indirectly or directly connected. The light emitting organic compound can be any organic compound that is able to emit light when activated by an electrical impulse or current. Light emitting organic compounds in the sense of the invention are all materials that can be used to generate light by activating the material by a current. The light emitting organic compounds can be fluorescent or phosphorescent. The light emitting organic compounds preferably have a molecular weight in a range of from 100 g/mol to 10 000 000 g/mol, or preferably in a range of from 1000 g/mol to 5 000 000 g/mol, or preferably in a range of from 5000 g/mol to 1 000 000 g/mol. As already mentioned above the light emitting organic compound can be an organic molecule which does not have polymeric structure, i.e. which does not contain three or more repeating units or a polymer. Examples of light emitting organic molecules which do not have polymeric structure have already been described above. Additionally or alternatively the light emitting organic compound can be a polymer. Preferably, the light emitting polymer is selected from the group consisting of an organometallic chelate, a perylene, a rubrene, a quinaquidrone, a polyphenylene, a vinylene and a polyfluorene. In a preferred embodiment of the multi-layer composite precursor, the light emitting polymer is a poly-phenylene, for example, poly(1,4-phenylene vinylene), poly[(1,4- phenylene-1,2-diphenylvinylene)], poly[2-methoxy-5-(2-ethylhexyloxy)-1,4-phenylenevinylene] or mixtures of at least two thereof. The substrate preferably comprises the light emitting organic compound in a range of from 1 to 100 wt.-%, preferably in a range of from 5 to 90 wt.-%, or preferably in a range of from 10 to 85 wt.-%, each based on the total weight of the substrate.

According to the invention, the substrate or the layer respectively comprises the first surface and the second surface, wherein the second surface is superimposed by a transparent electrically conducting layer. The transparent electrically conducting layer preferably comprises a conducting material. The conducting material can be any material known to the person skilled in the art that can be used to conduct an electrical current. The conducting material can be an electrical conductor material. The conducting material is preferably selected from the group consisting of a metal, a metal oxide, and a conductive polymer or at least one combination of at least two thereof. Preferably, the conducting material is selected from the group consisting of an indium tin oxide, calcium, a calcium compound, a barium compound, barium, and a polypyrrole, its derivatives and salts of both; or a combination of at least two thereof. The transparency of the transparent electrically conducting layer is preferably in a range of from 5 to 98 %, or preferably in a range of from 30 to 95 %, or preferably in a range of from 50 to 95 % to light in the visible region (from about 380 to about 750 nm). The thickness of the transparent electrically conducting layer is preferably in a range of from 0.01 to 10 000 µm, or preferably in a range of from 0.05 to 500 µm, or preferably in a range of from 0.1 to 50 µm. The electrically conducting layer preferably superimposes the second surface of the substrate in a range of from 1 to 100 %, or preferably in a range of from 10 to 100 %, or preferably in a range of from 20 to 100 % each based on the total area of the second surface of the substrate. In a preferred embodiment of the multi-layer composite, 100 % of the area of the second surface of the substrate is superimposed by the transparent electrically conducting layer.

The liquid phase can comprise any liquid or solid matter the person skilled in the art would use to carry the metal-organic compound and the silicon compound. The liquid phase can comprise different compounds as dispersion, emulsion or solution or mixtures thereof. The liquid phase superimposes at least a part of the first surface of the substrate. The liquid phase preferably superimposes the first surface of the substrate in a range of from 0.1 to 100 %, preferably in a range of from 1 to 90 %, or preferably in a range of from 3 to 80 % each based on the surface area of the first surface of the substrate. Preferably, the liquid phase comprises a liquid that is able to dissolve at least a part of the metal-organic compound or the first silicon compound. The liquid phase is preferably selected from the group consisting of an organic compound and an inorganic compound, preferably water; or mixtures thereof. In the case of the liquid phase comprising an organic compound, the organic compound is preferably selected from the group consisting of an alcohol, an amine, an ester, an ether, a hydrocarbon, a sulfoxide, a sulfone, a sulfonate, a lactone, a lactame a nitro compound, a nitrile and an oil or a combination of at least two thereof. Furthermore, it is preferred that the liquid phase comprises an organic compound selected from the group consisting of an alcohol, an aliphatic hydrocarbon, an aromatic hydrocarbon, a branched hydrocarbon, a cyclic alkene alcohol, a benzene, a halogenated hydrocarbon, a glycol ether, a glycol ether acetate, an essential oil, for example of leaves, flowers, wood, peel or seed a spike oil; or a combination of at least two thereof. The organic compound of the liquid phase is preferably selected from the group consisting of heptane, hexane, methanol, ethanol, butanol, propanol, acetone, γ-butyrolactone, N-methyl-2-pyrrolidone, acetonitrile, nitromethane, triethylamine, dimethylformamide, dimethylsulfoxide, sulfolane, ethylene carbonate, ethylene glycol monobutyl ether, dimethylcarbonate, propyleneglycol methylether acetate, propyleneglycol methylether acetate, rosemary oil, lavender or an spike oil, a turpentine oil, a campher oil, a lime oil and terpineol or mixtures thereof. Preferably, the organic compound is terpineol, for example an alpha, beta or gamma terpineol or mixture of these isomers. The liquid phase preferably comprises an organic compound in a range of from 0.1 to 99 wt.-%, or preferably in a range of from 1 to 95 wt.-%, or preferably in a range of from 10 to 90 wt.-%, or preferably in a range of from 20 to 80 wt.-%, each based on the total weight of the liquid phase.

In the case where the liquid phase comprises an inorganic compound, the inorganic compound is preferably selected from the group consisting of water, an acid and a base, especially hydrochloric acid, nitric acid, sulfuric acid and an alkaline lye or mixtures thereof. The liquid phase preferably comprises an inorganic compound in a range of from 0.1 to 99 wt.-%, or preferably in a range of from 1 to 95 wt.-%, or preferably in a range of from 10 to 90 wt.-% each based on the weight of the liquid phase.

The liquid phase can be superimposed on the first surface of the substrate by any method the person skilled in the art would use to supply an at least partially fluid component, like the liquid phase, onto a preferably solid substrate. Superimposing is preferably achieved by printing, laying, coating, impregnating or dipping or a combination thereof, preferably by printing. According to the invention, at least printing is a form of superimposing at least a part of a surface, wherein the liquid phase is applied via an aid in the form of a device onto the surface of the substrate. This can be achieved by different forms of aids. The liquid phase can, for example, be applied via a nozzle or valve by extruding, spraying or jetting. The liquid phase can be applied by coating e.g. brushing, roller coating, dip coating or curtain coating. Alternatively or additionally, the liquid phase can be applied or printed via a roll or a drum. As printing methods, gravure printing via a roll or ink-jet printing through an opening, e.g. a nozzle or valve, as well as the screen printing through a mesh, offset printing, flexo printing, tampon printing and spin coating are well known. During the superimposing process, pressure can be applied to the liquid phase or the substrate. Alternatively, the liquid phase is applied using gravity alone. In case of coating a substantial uniform coverage of a surface is desired. In case of printing, however, a two dimensional pattern is formed in the coverage of a surface.

The nozzle or valve can operate by a piezo element or a pneumatic valve as they are often used for ink-jet printers. These valves have the property of building portions of the applied liquid phase that might preferably be applied under pressure to the surface. The portions of the liquid phase preferably have a volume in a range of from 0.1 to 500 nl, or preferably in a range of from 1 to 100 nl, or preferably in a range of from 10 to 50 nl.

In the gravure printing process, the surface to be superimposed is fed between two rolls which are in contact with each other. One roll is called the impression roll and the other roll is called the gravure roll because the liquid phase comes into contact with it. By guiding the substrate between the contacting rolls with the first surface facing towards the gravure roll, the liquid phase can be transferred to the first surface of the substrate.

In the screen printing process the liquid phase is urged through a mesh onto the surface of the substrate. This can be achieved only by gravity or alternatively or additional by using a squeegee or doctor knife.

With these application or superimposing methods it is possible to create a pattern of the liquid phase onto the surface of the substrate. Preferably, lines or grids are formed by the superimposing process. The lines can have a width in a range of from 0.01 to 10 000 µm, preferably in a range of from 0.05 to 1 000 µm, or preferably in a range of from 0.1 to 500 µm. The lines of the grid can lie in the same ranges as mentioned for the lines.

The liquid phase comprises a metal-organic compound according to the invention. The liquid phase preferably comprises the metal-organic compound in a range of from 1 to 90 wt.-%, or preferably in a range of from 5 to 85 wt.-%, or preferably in a range of from 10 to 80 wt.-% each based on the total weight of the liquid phase. The metal-organic compound preferably comprises a metal component and an organic component. The metal component and the organic component are preferably bound via an ionic bonding or coordination of the metal and at least one nonmetal atom or both. Sometimes also covalent bonding between the metal and the organic component is possible.

The metal component of the metal-organic compound is preferably a material that is able to conduct electrical currents. It is preferred that the metal component comprises a metal or a semiconductor material. The metal component is preferably selected from the group consisting of alkali metals, alkaline earth metals, lanthanides, actinides, transition metals, semiconductor metals and poor metals or a combination of at least two thereof. The metal component is preferably selected from the group of transition metals, especially silver, gold, platinum, palladium, ruthenium, copper, nickel, cobalt, chromium, rhodium, iridium and iron or mixtures of at least two thereof, wherein silver is preferred.

The organic component of the metal-organic compound preferably comprises a molecule with at least one, at least two or more carbon atoms, preferably in a range from 2 to 100, or preferably in a range of from 4 to 50, or preferably in a range of from 5 to 20 carbon atoms. The organic component preferably also comprises one or two or more nonmetal atoms. It is preferred that at least one, two or more nonmetal atoms at least coordinate, or preferably form a bond, with the at least one metal of the above mentioned metals. The nonmetal atoms are preferably selected from the group of oxygen, hydrogen, sulfur, nitrogen, phosphorus, silicon, a halogen or mixtures of at least two thereof. Preferably, the organic component of the metal-organic compound comprises an organic moiety wherein the nonmetal atoms build at least one organic molecule together with the at least one, two or more carbon atom. According to the invention, the organic moiety comprises a C=O group. Further to the C=O group, the organic moiety preferably comprises at least two carbon atoms and preferably at least one nonmetal atom as mentioned above.

In a preferred embodiment of the multi-layer composite precursor, the organic moiety of the metal-organic component is selected from the group consisting of a carbonate, an oxalate, an ester, a carboxylate, a halogencarboxylate, a hydroxycarboxylate, an acetonate and a ketonate or mixtures of at least two thereof. For example, the organic moiety can be selected from the group consisting of acetate, proprionate, butanoate, ethylbutyrate, pivalate, cyclohexanebutyrate, acetylacetonate, ethylhexanoate, hydroxypropionate, trifluoracetate, hexafluor-2,4-pentadionate; and neodecanoate or mixtures of at least two thereof.

In a further preferred embodiment of the multi-layer composite precursor, the organic moiety of the metal-organic compound comprises acetylacetonate, neodecanoate or ethylhexanoate, or mixtures of at least two thereof.

Preferably, the metal-organic compound is selected from the group consisting of silver neodecanoate, silver ethylhexanoate, palladium neodecanoate and palladium ethylhexanoate or mixtures thereof.

Additionally, the multi-layer composite can comprise an organic moiety selected from the group consisting of a nitrate, a nitrite, a nitrile, an oxide, a borate, a sulfate, an amine, an amino acid, an acid amide, an azide and a fluoroborate or mixtures of at least two thereof.

Furthermore, the liquid phase comprises a first silicon compound according to the invention. The first silicon compound comprises at least one carbon atom and at least one nitrogen atom. The first silicon compound could be any silicon compound comprising at least one carbon atom and at least one nitrogen atom the person skilled in the art would use to improve the properties of the liquid phase and the subsequently formed metal layer out of it. The first silicon compound can support the metal in form of the metal layer to be more stable, more homogeneous, smoother or more conducting. The silicon compound can help in the conversion process of the metal-organic compound to the metal to be a faster and more reproducible process. A further function of the first silicon compound can be to strengthen the adhesion of the metal layer to the substrate where it is build on. The liquid phase preferably comprises the first silicon compound in a range of from 0.1 to 50 wt.-%, or preferably in a range of from 0.5 to 40 wt.-%, or preferably in a range of from 1 to 30 wt.-% each based on the total weight of the liquid phase.

A multi-layer composite precursor is preferred, wherein the first silicon compound is any compound having at least one or two or more silicon atoms, at least one or two or more carbon atoms and at least one or two or more nitrogen atoms. The first silicon compound can comprise further atoms like oxygen, sulfur, phosphor, fluorine, chlorine, bromine or others or mixtures of at least two thereof. Preferably the first silicon compound comprises at least one, at least two or more oxygen atoms. The first silicon compound preferably has a structure according to the formula VI:

(R¹)₃-Si-R²-N-(R³)₂ (VI)

in which
R¹ and R³ stand, independently of one another, for hydrogen, for hydroxyl, for an O-R group, wherein R is an optionally substituted C₁-C₂₀-alkyl group or C₁-C₂₀-oxyalkyl group, for an optionally substituted C₁-C₂₀-alkyl group or C₁-C₂₀-oxyalkyl group, optionally interrupted by 1 to 5 oxygen atoms and/or sulfur and/or phosphorus atoms, or jointly for an optionally substituted C₁-C₂₀-dioxyalkylene group or C₆-C₂₀-dioxyarylene group, the alkyl group, oxyalkyl group, dioxyalkylene group and dioxyarylene group can be linear, branched, cyclic and/or bi-cyclic;
R² stands for an optionally substituted C₁-C₂₀-alkyl group or C₁-C₂₀-oxyalkyl group, optionally interrupted by 1 to 5 oxygen atoms and/or sulphur and/or phosphorus atoms, or jointly for an optionally substituted C₁-C₂₀-dioxyalkylene group or C₆-C₂₀-dioxyarylene group

In a further embodiment of the multi-layer composite precursor the first silicon compound is selected from the group consisting of an aminosilane and an aminooxysilane or mixtures of at least two thereof. The first silicon compound is preferably selected from the group consisting of 3-aminopropyltriethoxysilan, 3-aminopropyltrimethoxysilan, 3-(ethoxydimethylsilyl)-propylamin, aminomethyltrimethylsilan and N-(2-aminoethyl) 3-aminopropyltrimethoxysilan or mixtures thereof.

In a preferred embodiment of the multi-layer composite precursor, the liquid phase further comprises a further silicon compound with at least two silicon atoms, wherein the at least two silicon atoms are connected via one oxygen atom. The further silicon compound can comprise further atoms like oxygen, sulfur, phosphor, fluorine, chlorine, bromine or others or mixtures thereof. Preferably the further silicon compound comprises at least one, at least two or more oxygen atoms. The further silicon compound preferably has a structure according to the formula (VII):

(R¹)₃-Si-O-Si-(R³)₃ (VII)

in which
R¹ and R³ stand, independently of one another, for hydrogen, for hydroxyl, for an O-R group, wherein R is an optionally substituted C₁-C₂₀-alkyl group or C₁-C₂₀-oxyalkyl group, for a (-Si-O)ₙ group, wherein n is a natural number from 1 to 20000, or preferably from 1 to 1000; or preferably from 1 to 100; for an optionally substituted C₁-C₂₀-alkyl group or C₁-C₂₀-oxyalkyl group, optionally interrupted by 1 to 5 oxygen atoms and/or sulfur and/or phosphorus atoms, or jointly for an optionally substituted C₁-C₂₀-dioxyalkylene group or C₆-C₂₀-dioxyarylene group, the alkyl group, oxyalkyl group, dioxyalkylene group and dioxyarylene group can be linear, branched, cyclic and/or bi-cyclic;

A multi-layer composite precursor is preferred, wherein the further silicon compound is selected from the group consisting of a siloxane or a polysiloxane or mixtures thereof. Siloxanes can be selected from the group consisting of hexamethyldisiloxane, octamethyltrisiloxane, decamethyltetrasiloxane, hexamethylcyclotrisiloxane, octamethylcyclotetrasiloxane, decamethylcyclopentasiloxane or mixtures of at least two thereof. Polysiloxanes can be selected from the group consisting of polydimethylsiloxane, polydiethylsiloxane, polydibutylsiloxane, polypropylsiloxane, polypentylsiloxane and polydiphenylsiloxane or mixtures of at least tow thereof. The polysiloxanes preferably have a molecular weight in a range of from 100 to 1 000 000 g/mol, or preferably in a range of from 500 to 100 000 g/mol, or preferably in a range of from 1 000 to 500 000 g/mol.

The liquid phase comprises the further silicon compound in a range of from 0.1 to 50 wt.-%, or preferably in a range of from 0.5 to 40 wt.-%, or preferably in a range of from 1 to 30 wt.-% each based on the total weight of the liquid phase.

According to a preferred embodiment of the multi-layer composite precursor, the liquid phase comprises the first silicon compound or the further silicon compound or both in a range of from 0.1 to 50 wt.-% based on the total weight of the liquid phase.

In one multi-layer composite precursor embodiment according to the invention, it is preferred for the metal-organic compound to be converted into a metal, wherein the converted metal has a content of an organic moiety of less than 10 wt.-%, preferably of less than 8 wt.-%, or preferably of less than 5 wt.-% each based on the total weight of the metal. Occasionally the metal layer can comprise the organic moiety in a range of from 0.1 to 10 wt.-%, or preferably in a range of from 0.1 to 8 wt.-%, or preferably in a range of from 0.1 to 5 wt.-% each based on the total weight of the metal. The conversion of the metal-organic compound is preferably established by heating at least the liquid phase, preferably the entire multi-layer composite precursor.

The temperature of the conversion of the metal-organic compound into a metal, also called conversion temperature, is dependent on different factors. The conversion temperature, for example, depends on the composition of the liquid phase. It can also depend on the surrounding conditions, like pressure, humidity or light intensity, which could be IR, synthetic light or daylight. The heating can preferably be established by a method selected from the group consisting of irradiation with electromagnetic waves and convection or a combination thereof. The irradiation can preferably be provided by a lamp, for example by an excimer lamp, flash lamp, UV- or an infrared lamp. The convection can preferably be provided to the liquid phase by a hot fluid, for example hot air or hot liquid. Preferably, the multi-layer composite precursor is heated with the liquid phase in a cabinet that is heated electrically. The fluid in the cabinet can be selected from the group consisting of air, nitrogen gas and inert gas or mixtures of at least two thereof. The liquid phase is preferably heated to a temperature in a range of from 100 to 250 °C, or preferably in a range of from 110 to 200 °C, or preferably in a range of from 120 to 180 °C. By heating the liquid phase to a temperature in these ranges, the metal-organic compound preferably changes its composition. After the change of composition, the liquid phase has preferably turned into a metal layer. The metal layer can comprise at least 50 wt.-%, preferably at least 70 wt.-%, or preferably at least 90 wt.-% each based on the total weight of the metal layer, a metal. Furthermore preferably the metal layer can comprise a metal in a range of from 5 to 90 wt.-%, preferably in a range of from 10 to 80 wt.-%, or preferably in a range of from 15 to 60 wt.-% each based on the total weight of the metal layer. Further possible properties and compositions of the metal layer are described in connection with the multi-layer composite and the composite below. These properties and composition can also apply for the metal layer described in connection with the multi-layer composite precursor.

In a preferred embodiment of the multi-layer composite precursor, the liquid phase further comprises a component selected from the group consisting of
- M1.: an organic compound selected from the group consisting of an alcohol, an organic acid, an amine, a diamine an ester, an ether, a ketone, a silicone, a sulfonate and a polymer or mixtures of at least two thereof;
- M2.: an inorganic compound selected from the group consisting of water, a silane, an inorganic ester, a ceramic, a glass, a polymer and a metal or mixtures thereof;
or mixtures thereof.

The additives M1 or M2 are preferably chosen by the person skilled in the art in a way to achieve at least one positive effect on the behavior and processability of the liquid phase, for example when using it for superimposing at least a part of the substrate. The content of the components M1 or M2 is preferred to be in a range of from 0.1 to 50 wt.-%, preferably in a range of from 0.1 to 30 wt.-%, or preferably in a range of from 0.1 to 10 wt.-% in total each based on the total weight of the liquid phase. The content of water in the liquid phase is preferred to be in a range of from 0.01 to 40 wt.-%, preferably in a range of from 0.1 to 20 wt.-%, or preferably in a range of from 0.1 to 10 wt.-% each based on the total weight of the liquid phase

The organic compound M1 is preferably selected from the group consisting of an alkyl alcohol, an aromatic alcohol, a primary amine, a secondary amine, a tertiary amine, a quaternary amine, an alkyl amine and an aromatic amine, an ether, a polyether, a ketone, a carboxylic acid, an alcalic sulfonate, a cyclic sulfonate, a aromatic sulfonate and a polymer or mixtures thereof. Examples of components of the organic compound M1 are methanol, ethanol, a propanol, a butanol, a hexanol, a heptanol, a decanol, methylamine, dimethylamine, trimethylamine, a phenylamine like mono-, di- or triphenylamine, dimethylether, diethylether, polyethylenether, polypropylenether, aceton, butanon, 2-pentanon, formic acid, acetic acid, oxalic acid, mellitic acid, methansulfonate, ethansulfonate, propansulfonate, trifluormethansulfonate, p-toluensulfonate, benzenesulfonate and any polymer listed for the substrate or mixtures of at least two thereof. The content of any of the components of M2 in the liquid phase is preferred to be in a range of from 0.01 to 40 wt.-%, preferably in a range of from 0.1 to 20 wt.-%, or preferably in a range of from 0.1 to 10 wt.-% each based on the total weight of the liquid phase

The inorganic compound M2 is preferably selected from the group consisting of water, a phosphoric acid ester, a sulfuric acid ester, a nitric acid ester, a boric acid ester, a ceramic comprising a BeO, a ZrO, a Fe₂O₃, a Al₂O₃ or a silicate like feldspar, an aluminium oxynitride, a silica, a polysilazane and, a polysiloxane or mixtures of at least two thereof. The content of any of the components of M3 in the liquid phase is preferred to be in a range of from 0.01 to 40 wt.-%, preferably in a range of from 0.1 to 20 wt.-%, or preferably in a range of from 0.1 to 10 wt.-% each based on the total weight of the liquid phase

Some of the compounds belonging to the groups M1 or M2, like the carboxylic acids, have the ability to support the stability of the metal-organic compound in the liquid phase. Furthermore alcohols or carboxylic acids or other solvents can lower the surface tension of the liquid phase, supporting the applicability of the liquid phase to the substrate.

The multi-layer composite precursor is preferred, wherein the metal-organic compound comprises a metal selected from the group consisting of silver, gold, platinum and palladium or at least two of them.

In a preferred embodiment of the multi-layer composite precursor, the metal-organic compound comprises silver. The metal-organic compound is further preferred to comprise silver as metal in a range of from 10 to 100 wt.-%, or preferably in a range of from 20 to 90 wt.-%, or preferably in a range of from 30 to 80 wt.-% each based on the total weight of metal in the metal-organic compound. Furthermore, the metal-organic compound is preferred to comprise silver-acetylacetonate, silver-neodecanoate or silver-ethylhexanoate, or mixtures of at least two thereof. The metal-organic compound is further preferred to comprise silver-acetylacetonate, silver-neodecanoate or silver-ethylhexanoate or mixtures of at least two thereof in a range of from 10 to 100 wt.-%, or preferably in a range of from 20 to 90 wt.-%, or preferably in a range of from 30 to 80 wt.-% each based on the total weight of the metal-organic compound

In a further embodiment it is preferred that the metal-organic compound comprises a further metal selected from the group consisting of ruthenium, rhodium, palladium, osmium, iridium, platinum and gold or mixtures of at least two thereof. Palladium or platinum are preferred further metals comprised by the metal-organic compound Preferably, the metal-organic compound comprises one or two or more of these further metals, each in a range of from 0.1 to 30 wt.-%, or preferably in a range of from 1 to 20 wt.-%, or preferably in a range of from 1 to 10 wt.-% each based on the weight of the metal of the metal-organic compound.

The addition of the further metal as part of the metal-organic compound can stabilize the heated or sintered metal layer against oxidation. Furthermore the further metal can oppress possible battery effects, where parts of the metal layer are not covered by any further layer.

The multi-layer composite precursor is preferred, wherein the liquid phase has a thickness in a range of from 0.1 to 5000 µm, or preferably in a range of from 0.5 to 3000 µm, or preferably in a range of from 1 to 50 µm. After heating the liquid phase at a temperature in a range of from 100 to 500 °C to obtain a metal layer, the metal layer can have a thickness in a range of from 0.001 to 50 µm, preferably in a range of from 0.01 to 30 µm, or preferably in a range of from 0.05 to 30 µm. The width of the metal layer preferably is in a range of from 1 to 500 µm, or preferably in a range of from 3 to 200 µm, or preferably in a range of from 5 to 100 µm.

A preferred multi-layer composite precursor embodiment is, wherein the liquid phase has a viscosity in a range of from 100 to 50000 mPa*s, or preferably in a range of from 500 to 10000 mPa*s, or preferably in a range of from 1000 to 5000 mPa*s.

A further preferred embodiment of the multi-layer composite precursor is, wherein the substrate comprises a component selected from the group consisting of a ceramic, a polymer, a glass and a metal or a combination thereof. A ceramic material is usually an inorganic, non-metallic, often crystalline oxide, nitride or carbide material. The ceramic comprises preferably at least one element selected from the group consisting of silicon, boron, carbon, aluminum, tungsten and beryllium or mixtures of at least two thereof. Non-crystalline ceramics are often called glasses. The metal is preferably selected from the group consisting of titanium, silver, gold, aluminum, palladium, platinum, copper, iron and nickel or mixtures of at least two thereof.

A further aspect of the invention relates to a process for preparing a composite comprising the steps of:
a) providing a substrate, wherein the substrate comprises
   1. a light emitting organic compound with
   2. a first surface and
   3. a second surface,
   wherein the second surface is superimposed by a transparent electrically conducting layer,
b) applying a liquid phase onto at least a part of the first surface in order to obtain a composite precursor, wherein the liquid phase comprises a metal-organic compound and wherein the liquid phase further comprises a first silicon compound, wherein the silicon compound comprises at least one carbon atom and at least one nitrogen atom.
c) treating the composite precursor at a temperature in a range from 100 to 250 °C, in order to obtain the composite;
wherein the metal-organic compound comprises an organic moiety, wherein the organic moiety comprises a C=O group.

Unless otherwise defined in the following, the properties required of the components and compounds used to provide a composite according to the process according to the invention are as in the above description and definitions relating to the multi-layer composite precursor.

In a first step of the process for preparing a composite a substrate is provided. The substrate can be provided by any means which allows the further steps b) and c) of the process to be realized. Examples of ways for providing a substrate can be selected from the group consisting of laying, uncoiling and deploying of the substrate or a combination of at least two thereof. The substrate can be provided in any way which ensures that the first surface of the substrate is accessible for applying the liquid phase to the substrate. The materials and properties of the substrate can be the same as already described for the multi-layer composite precursor above. The substrate is preferably flexible. It is preferred that the substrate is superimposed by a transparent electrically conducting layer on the second surface. The transparent electrically conducting layer can have the properties as already described for the transparent electrically conducting layer of the multi-layer composite precursor above. In a preferred embodiment of the process for preparing a composite, the area of the second surface of the substrate is superimposed by a layer comprising indium tin oxide or a conductive polymer with an area in a range of from 50 to 100 %, or preferably in a range of from 60 to 100 %,or preferably in a range of from 70 to 100 % of the total area of the second surface. It is preferred to store the substrate on a roll or coil before providing it in step a) of the process according to the invention. In a particularly preferred embodiment of the process the substrate is provided by transfer from roll to roll. To transfer the substrate from roll to roll, the substrate can be provided on a first roll wherein the loose end of the substrate is fixed to a second roll. By this fixation of the substrate between two rolls, at least one surface of the substrate is accessible for the next step of the process according to the invention. The accessible surface is preferably the first surface of the substrate. The accessible surface of the substrate during at least one step of the process is preferably in a range of from 1 mm² to 1000 m², or preferably in a range of from 10 mm² to 500 m², or preferably in a range of from 1 cm² to 100 m². The accessible surface of the substrate is defined according to the invention as the surface range that is actually used for one of the steps of the process according to the invention. For example, the surface that is defined as accessible for step b) of the process is the surface that actually comes into contact with the liquid phase at the moment of application of the liquid phase.

The substrate comprises a light emitting organic compound according to the invention. Light emitting organic compounds have already been described for the multi-layer composite precursor. These can also be used in the process for preparing a composite according to the invention.

In a second step b) of the process for preparing a composite according to the invention, a liquid phase is applied to at least a part of the first surface of the substrate in order to obtain a composite precursor for example as described above. The liquid phase can exhibit any of the components or properties described for the multi-layer composite precursor above. The liquid phase at least comprises a metal-organic compound and a first silicon compound. For the compounds of the first silicon, their properties, the ranges and further details it is referred to those already mentioned in the context of the multi-layer composite precursor above.

The application of the liquid phase can be achieved by any means that is suitable for the application of a liquid to a solid material, as is the case for the first surface of the substrate. Superimposing is preferably achieved by printing, laying, coating, impregnating or dipping or a combination thereof, preferably by printing. According to the invention, at least printing is a form of superimposing at least a part of a surface, wherein the liquid phase is applied via an aid in the form of a device onto the surface of the substrate. As mentioned above, known application methods are those in which the liquid phase is applied with pressure to the surface or methods in which gravity is used to apply the liquid to the surface. Methods in which pressure is applied when applying the liquid to the surface are for example some printing methods, like ink jet printing, screen printing, offset printing, tampon printing or gravure printing amongst others. A method for applying the liquid without pressure can be to dip the substrate into a bath of liquid or by dropping the liquid onto the surface of the substrate. There are also printing methods that don't use pressure when applying the liquid to the surface. In a preferred embodiment of the process for preparing a composite or a composite precursor, a gravure printing or a screen printing process is used for applying the liquid phase to the first surface of the substrate.

In the gravure printing process, also called roll to roll (R2R) process, the liquid phase is sucked into a gravure image of a gravure roll by leading the surface of the gravure roll through a bath of liquid phase. Then the first surface of the substrate is brought into contact with the surface of the gravure roll by leading it through a gap built by the gravure roll and an impression roll. By rotating the rolls in opposite directions the substrate is pressed through the gap and liquid superimposes the surface of the substrate that comes into contact with the liquid phase. Preferably the gravure roll provides a grid pattern, more preferably a quadratic pattern; however it can provide any other form like rectangular, circular, oval or a combination thereof. The grid size of the gravure roll preferably is in a range of from 0.01 to 10 000 µm, preferably in a range of from 0.05 to 1 000 µm, or preferably in a range of from 0.1 to 500 µm.

In the alternative screen printing process the liquid phase is forced by a squeegee through a mesh onto the substrate. The mesh can be partially covered or closed and partially open whereby the open areas can define the printed pattern. The geometry of the mesh preferably is quadratic; however it can provide any other form like rectangular, circular, oval or a combination thereof. The mesh can be provided with mesh width in a range of from 1.0 to 1000 µm, preferably in a range of from 5 to 500 µm, or preferably in a range of from 10 to 100 µm.

After the step b) of applying the liquid phase to the first surface of the substrate the liquid phase will show a pattern similar to the pattern of the application method. For example, for the gravure printing or the screen printing process, the liquid phase will show the pattern of the gravure roll of the gravure printing or the mesh pattern of the screen printing mesh. In both cases, gravure printing and screen printing, the pattern of liquid phase applied to the surface shows a grid size. The grid size of the patterned liquid phase after gravure printing or screen printing is preferably in a range of 0.01 to 1000 µm, preferably in a range of from 0.05 to 500 µm, or preferably in a range of from 0.1 to 100 µm.

The third step c) of the process according to the invention is a treatment of the composite at a temperature in a range of from 100 to 250 °C, preferably in a range of from 100 to 220 °C, or preferably in a range of from 100 to 180 °C, or preferably in a range of from 100 to 150 °C. The temperature is applied to the composite precursor in order to convert the metal-organic compound into a metal in order to achieve a metal layer. After step c) the composite preferably comprises a metal layer. It is preferred to keep the temperature as low as possible to prevent a destruction of the substrate or any other layer of the composite precursor. Especially when polymers are used as substrate, it can be useful to keep the temperature below the melting point or the softening temperature of the substrate. The conversion temperature of the metal-organic compound into a metal can be influenced by the choice of the organic moiety of the metal-organic compound and the other components of the liquid phase. Furthermore, the bonding of the metal layer to the substrate can be influenced by the choice of components of the liquid phase. It has been found that the bonding of the metal layer to the substrate can be strengthened by adding at least one silicon compound to the liquid phase. The bonding of the metal layer achieved by heating a liquid phase with the first silicon compound can be strengthened by a factor in a range of from 1.5 to 10, preferably in a range of from 2 to 8, or preferably in a range of from 2.5 to 7, in relation to the bonding of the same metal-organic compound without comprising the first silicon compound. The verification of the strength of the bonding of the metal layer can be provided by executing the SAICAS test, which is described in detail in the test part below.

The treatment of the composite precursor at a temperature in a range from 100 to 250 °C can be achieved by any means known for temperature treatment of such materials. Preferably, the temperature is applied by a convection oven. The temperature application could also be achieved by using hot air, irradiation or hot fluids or a combination thereof. After heating the multi-layer composite precursor to achieve a metal-layer composite the silicon compound can still be part of the metal layer. Alternatively a part or the entire silicon compound could be converted into a different silicon compound. It is preferred that the metal layer comprises the silicon compound in an amount as the silicon compound was added to the liquid phase. Preferably, the amount of silicon compound in the metal layer is in a range of 0.1 to 50 %, or preferably in a range of 1 to 20 %, or preferably in a range of from 5 to 10 % based on the total weight of the metal layer.

In a preferred embodiment of the process the organic moiety of the metal-organic component is selected from the group consisting of a carbonate, an oxalate, an ester, a carboxylate, a halogencarboxylate, a hydroxycarboxylate, an acetonate and a ketonate or mixtures of at least two thereof. Details for composition and properties of these materials described above for the multi-layer composite precursor are also applicable for the process according to the invention.

In a further preferred embodiment of the process, the organic moiety of the metal-organic compound comprises acetylacetonate or neodecanoate or ethylhexanoate or mixtures of at least two thereof.

Preferably, the metal-organic compound is selected from the group consisting of silver neodecanoate, silver ethylhexanoate, palladium neodecanoate and palladium ethylhexanoate or mixtures thereof.

Furthermore, it is preferred for the first silicon compound to be selected from the group consisting of an aminosilane and an aminooxysilane or mixtures of at least two thereof. The first silicon compound is preferably selected from the group consisting of 3-aminopropyltriethoxysilane, 3-aminopropyltrimethoxysilane, 3-(ethoxydimethylsilyl)-propylamine, aminomethyltrimethylsilane and N-(2-aminoethyl) 3-aminopropyltrimethoxysilane or mixtures of at least two thereof.

In a preferred process, the liquid phase comprises a further silicon compound with at least two silicon atoms, wherein the at least two silicon atoms are connected via one oxygen atom. The further silicon compound is preferably added to the liquid phase to increase the processability of the liquid phase. The further silicon compound can, for example, act as anti-foaming component.

In a further preferred embodiment of the process, the further silicon compound is selected from the group consisting of a siloxane or a polysiloxane or mixtures thereof.

For the compounds of the further silicon, their properties, the ranges and further details it is referred to those already mentioned in the context of the multi-layer composite precursor above.

In a further preferred embodiment of the process, the first silicon compound or the further silicon compound or both are comprised in the liquid phase in a range of from 0.1 to 50 wt.-%, or preferably in a range of from 0.5 to 40 wt.-%, or preferably in a range of from 1 to 30 wt.-% each based on the total weight of the liquid phase.

Furthermore, in one embodiment of the process according to the invention, it is preferable for the metal-organic compound to be converted into a metal, wherein the metal has a content of an organic moiety of less than 10 wt.-%, preferably in a range of from 0.1 to 10 wt.-%, or preferably in a range of from 0.1 to 5 wt.-% each based on the weight of the metal.

In a further preferred embodiment of the process the liquid phase further comprises a component selected from the group consisting of
- M1.: an organic compound selected from the group consisting of an alcohol, an organic acid, an amine, a diamine an ester, an ether, a ketone, a silicone, a sulfonate and a polymer or mixtures of at least two thereof;
- M2.: an inorganic compound selected from the group consisting of water, a silane, an inorganic ester, a ceramic, a glass, a polymer and a metal or mixtures of at least two thereof;
or mixtures thereof.

The compounds, their properties, ranges and further details as already mentioned in the context of the multi-layer composite precursor above also apply for the components M1 or M2 for the process.

Furthermore, a process is preferred in which the metal-organic compound comprises a metal selected from the group consisting of silver, gold, platinum and palladium or at least two thereof. Furthermore, in a preferred embodiment of the process the metal-organic compound comprises silver.

In a further preferred embodiment of the process, the composite comprises a metal layer, wherein the metal layer has a thickness in a range of from 0.01 to 10 µm, or preferably in a range of from 0.05 to 8 µm, or preferably in a range of from 0.1 to 1 µm after step (c).

Furthermore, a process is preferred, wherein the liquid phase has a viscosity in a range of from 100 to 50000 mPa*s, or preferably in a range of from 500 to 10000 mPa*s, or preferably in a range of from 1000 to 5000 mPa*s.

In a preferred embodiment of the process, the substrate comprises a component selected from the group consisting of a ceramic, a polymer, a glass and a metal or a combination of at least two thereof.

In a further aspect of the invention, a composite obtainable according to the aforementioned process and process embodiments is provided.

Furthermore, one aspect of the invention is a multi-layer composite comprising:
i. a substrate, and
ii. a metal layer;
wherein the metal layer has at least one, or all, of the following properties:
- P1.: a surface roughness in a range of 0.1 nm to 1000 nm, preferably in the range of 0.25 to 700 nm, and more preferably in the range of 0.5 to 500 nm;
- P2.: a resistivity in a range of 1 x 10⁻⁶ Ω·cm to 1 x 10⁻³ Ω·cm; preferably in a range of 1.5 x 10⁻⁶ Ω·cm to 1 x 10⁻⁴ Ω·cm or preferable in the range of 2 x 10⁻⁶ Ω·cm to 1 x 10⁻⁵ Ω·cm;
- P3.: a crystal-size in a range of 1 nm to 10 µm, preferably in the range of 5 nm to 5 µm and more preferably in the range of 10 nm to 2.5 µm; or
- P4.: a thickness in a range of from 0.001 to 50 µm, preferably in the range of from 0.005 to 25 µm and more preferably in the range of from 0.007 to 20 µm.

The roughness of the surface of the metal layer can be measured with an atomic force microscope (AFM). The surface resistivities of the metal layer can be measured with a four point probe resistivity measurement. The crystal-size and the thickness of the metal layer can be measured with a scanning electron microscope (SEM). The way of executing these methods is described in the test method section below. Preferred combinations of the above properties are: P1, P2, P3, or P2. P3, P4, or P1, P3, P4, or P1, P2, P4, or P1, P2, P3, or P1, P2, or P2, P3, or P3, P4, or P1, P4, or P2, P4, or P1 P3.

The material and properties of the substrate can be the same as already described for the substrate of the multi-layer composite precursor above. Also the material of the metal layer can be those described for the metal layer of the precursor above. The metal layer composite can be produced by a process for preparing a composite described above. If the multi-layer composite is processed in the already described process for preparing a composite the metal layer can comprise at least one silicon compound in a range as it was added to the liquid phase.

A further aspect of the invention is an electronic component comprising a composite according to the already described embodiments of the composites.

In a preferred embodiment of the electronic component, the electronic component is selected from the group consisting of an Organic Light Emitting Diode (OLED), a transistor and a touch screen. With the combination of the composite with different electronic components, the increase in robustness and longevity could be achieved for the whole electronic component.

The above and other features and advantages of the invention will be apparent from the following description, by way of example, of embodiments of the invention with reference to the accompanying drawings. The particular features can be realized here by themselves or several in combination with one another. The invention is not limited to the embodiment examples. The embodiment examples are shown in diagram form in the figures. In this context, the same reference symbols in the individual figures designate elements which are the same or the same in function or correspond to one another with respect to their functions.

### TEST METHODS

### Determination of the surface resistivity

The resistivity is a fundamental property of a material. To measure the resistivity of a layer a rectangular or cubical part of the layer is contacted with two electrical contacts at two opposing ends of the rectangle or cube. By applying a known voltage V [V] to the contacts, measuring the current I [A] and knowing the length L [cm], width W [cm] and thickness T [cm] of the tested part of the layer it is possible to calculate the resistivity R*(T*W)/L indicated in [Ω·cm] by using the Ohm's law R=V/I [ohm]. If not specified otherwise the resistivity has been measured by using copper contacts with a contacting surface of 1 * 1 mm to the opposing ends of the layer to be analysed. A known voltage is applied to the contacts in a range of from 0.01 to 1 V and the current is measured via an amperemeter. The measurement was established at room temperature, normal pressure and a relative humidity of 50 %.

### Determination of the sheet resistance

For measuring the sheet resistance of a multi-layer composite precursor or of a multi-layer composite according to the invention a device "CMT-SR 3000" by the company AiT Co., Ltd. was used. For the measuring 4 point measuring principle is applied. Therefore two outer probes in form of pins apply a constant current and tow inner probes measure the voltage on a rectangular probe. The sheet resistance is deducted by the Ohm's law in Ohm/square by using the equation surface resistance = R*W/L [Ω/sq].
As the sheet resistance can be influenced by the dopant concentration, the resistivity can vary from the outside to the inside of the composite precursor or the composite. To determine the average sheet resistance generally the measurement is performed on 25 equally distributed spots of the composite precursor or composite, wherein the spots all had equal distances to each other.

In an air conditioned room with a temperature of 23 ± 1 °C all equipment and materials are equilibrated to the temperature of 23 °C before the measurement. To perform the measurement the "CMT-SR 3000" is equipped with a 4-point measuring head with sharp tips in order to penetrate layers on the metal layer like an anti-reflection and/or passivation layer. A current of 10 mA is applied to the 4 probes for 3 seconds. The measuring head, incorporating the 4 probes, is brought into contact with the non metalized wafer material and the measuring of the voltage is started. The voltage is measured by a digital voltmeter (DVM) with a measuring range of 0 V to 2000 mV. After measuring 25 equally distributed spots on the wafer, the average sheet resistance is calculated in Ohm/square.
The pin spacing of the four probes was 25 mils ~ 50 mils, wherein:
- Pin Load : 10 gram/pin ~ 250 gram/pin, preferably about 20 gram/pin.
- Pin radius : 12.5 micron~500 micron (polished 2µ diamond), preferably 100 micron
- Tolerance : ± 0.01 mm
- Pin Needles : Solid Tungsten Carbide ϕ0.40 mm
The measuring time was 3 ± 1 sec/point.

### SAICAS test

The SAICAS test is a method that can evaluate the peel strength and thus the adhesion along the interface between a film and a substrate by measuring the horizontal (Fh) and vertical (Fv) cutting forces and the depth (d) of a cutting blade. The blade, made from crystal diamond and boron nitride has a width of about 1 mm. The tip of the blade is formed by two arms that are angled angled to each other. The two arms span an angle of about 60 ° of the two arms of the blade, ending in the tip. During application the angle of the blade towards the surface is about 10 ° and the angle towards the perpendicular to the surface is about 20 °. The blade first cuts into the material, e.g. a film, which is build by the outmost layer of the composite or the composite precursor opposite to the substrate. The cutting is provided with a slope of 1 µm on a distance of 500 µm. The mechanical strength while cutting is measured in Mpa by measuring the shear force. The forces Fh and Fv drastically change when the blade reaches the interface between two layers, for example between the outmost layer and the following layer. At each interface between two layers the blade movement changes from cutting to peeling mode. In the peeling mode the surface of the upper layer is peeled of. The energy applied for peeling off the layer is a measure for the adhesion force of the two layers to each other at the interface. The adhesion strength is measured in kN/m by using blade width and measuring shear force. In the peeling mode, Fh and Fv also remain constant. Fh is regarded as the peeling force between the outmost layer and the following layer. Layers with a thickness in a range of from 1 to 1000 µm can be evaluated with this method.

### Cross cut test

ISO 2409:2007 describes a test method for assessing the resistance of paint coatings (comparable to the layers of the composite or the composite precursor of the invention) to separation from substrates when a right-angle lattice pattern is cut into the coating (e.g. a layer), penetrating through to the substrate. The property measured by this empirical test procedure depends, among other factors, on the adhesion of the coating or layer to either the preceding layer or the substrate. This procedure is not to be regarded, however, as a means of measuring adhesion.

The method described may be used either as a pass/fail test or, where circumstances are appropriate, as a six-step classification test. When applied to a multi-coat or multi-layer system, assessment of the resistance to separation of individual layers of the coating, the composite precursor or the composite from each other may be made.

The test can be carried out on finished objects and/or on specially prepared test specimens.

The method is not suitable for coatings of total thickness greater than 250 micrometres or for textured coatings.

### 2D surface profiler

To establish a 2D surface profile, a P-16+ of the company KLA-Tencor Corp. was utilized. The herewith described method applies for all examples of a 2D surface profile if not specified otherwise. By this profiler a resolution of the two dimensional (2D) structure of the composite or composite precursor surface can be established in a range of up to 0.1 nm in both directions. For the measurement of the 2D structure of the surface of the sample, the sample is positioned on a flexible plate. The surface is scanned with a stroke range of 20 µm to 1 mm with a velocity range of from2 to 100 µm, at room temperature.

### 3D surface profiler

To establish a three dimensional (3D) surface profile, a SIS-2000 of the company SNU Precision Co., Ltd. was utilized. The herewith described method applies for all examples of a 3D surface profile if not specified otherwise. By this profiler a resolution of the 3D structure of the composite or composite precursor surface can be established in a range of up to 0.1 nm in each direction. For the measurement of the 3D structure of the surface of the sample, the sample is positioned on a substrate. The surface is scanned by an enhanced phase scanning interferometer in a range of from 30 * 30 µm to 100 * 100 µm with a velocity of 10 µm/sec at room temperature.

### Atomic force microscopy (AFM)

To establish an atomic force microscopy image an n-Tracer of the company Nano Focus Inc. was utilized. The herewith described method applies for all examples of a AFM scan if not specified otherwise. The optics of the used n-Tracer provides a field of view in a range of 500 µm * 500 µm, a magnification of 500 fold, a resolution of around 1 µm. A white LED light source is used. The dimensions of the probed sample can be in a range of a diameter < 40 mm, a height < 10 mm. The scanner range lies for the xy scan in a range of 30 * 30 µm to 80 * 80 µm, and for the z scan range around 6 µm. The surface is normally scanned with the AFM tip at room temperature.

### Scanning electron microscopy (SEM)

To establish a scanning electron microscopy, a S-4800 II Filed Emission SEM of the company Hitachi High Technology America, Inc. was utilized. The herewith described method applies for all examples of a SEM scan if not specified otherwise. The resolution of the SEM device lies in the range of 1 to 2 nm. The microstructure of the surface is observed by SEM in the magnitude range of x500 to x100000.

### EXAMPLES:

### 1. Preparation of metal-organic compounds

### 1.1. Preparation Example 1 for a metal-organic compound according to the invention

In a beaker glass 65.8 g (233 mmol) of silver neodecanoate (Heraeus Holding GmbH), with a content of approx. 38 wt.-% Ag were dissolved in 31.8 g of terpineol under heating in about 30 min from room temperature to 70 °C. After cooling down to room temperature 1.0 g Byk 065 and 1.0 g of 3-aminopropyltriethoxy silane (supplied by Sigma-Aldrich Co. LLC) are added. The mixture is homogenized by three passes over a triple roll mill Exakt E80 (from EXAKT Advanced Technologies GmbH), which is provided with three ceramic rolls. The distance between the first and second roll was 45 µm. The distance between the second and the third roll was 15 µm. The first roll was operated at a velocity of 50 rpm. The third roll was operated at a velocity of 150 rpm

The paste is screen printable and can be adjusted by thinning in a range of from 10 to 90 vol.- %, preferably in a range of from 40 to 60 vol.-% with proper solvents, like any terpineol or turpentine to other application methods, e.g. gravure printing. In this example the paste is diluted by terpineol to a content of 50 vol.-%.

### 1.2. Preparation Example 2 for a metal-organic compound according to the invention

In a beaker glass 65.8 g (233 mmol) of silver neodecanoate (Heraeus Holding GmbH), with a content of approx. 38 wt.-% Ag were dissolved in 34.2 g of terpineol under heating in about 30 min from room temperature to 70 °C. After cooling down to room temperature the mixture is homogenized by three passes over a triple roll mill Exakt E80 (from EXAKT Advanced Technologies GmbH) using the same parameters of the rolls as provided for the triple roll mill in example 1.1..

The paste is screen printable and can be adjusted by thinning in a range of from 10 to 90 vol.- %, preferably in a range of from 40 to 60 vol.-% with proper solvents, like any terpineol or turpentine to other application methods, e.g. gravure printing. In this example the paste is diluted by terpineol to a content of 50 vol.-%.

### 1.3. Preparation Example 3 for a metal-organic compound according to the prior art

In beaker glass 13,2 g (47 mmol) silver neodecanoate (Heraeus Holding GmbH), with a content of approx. 38 wt.-% Ag, 49,0 (237 mmol) silver acetylacetonate (supplied by Sigma-Aldrich Co. LLC) and 37.8 g terpineol (mixture of α-, β- and γ-terpineol in any proportion) are premixed with a spatula at room temperature. The mixture is homogenized by four passes over a triple roll mill Exakt E80 (from EXAKT Advanced Technologies GmbH) using the same parameters of the rolls as provided for the triple roll mill in example 1.1.. By homogenizing the mixture a grain size below 5 µm is reached. Preferably the grain size is in a range of from 1 to 10 µm, preferably in a range of from 1 to 5 µm.

The paste is screen printable and can be adjusted by thinning in a range of from 5 to 30 vol.-%, preferably in a range of from 10 to 20 vol.-% with proper solvents, like any Terpineol or Turpentine to other application methods, e.g. gravure printing. In this example the paste is diluted by Terpineol to a content of 10 vol.-%.

### 2. Provision of multi-layer composites

### 2.1. Composite Example 1 - Spin Coating

In this example two different metal-organic compounds, made according to preparation examples 1.1 were brought onto a substrate by spin coating to achieve a composite according to the invention. The materials and conditions of this process are summarized in table 1. In a first step the substrate (here indium tin oxide layer of 150 nm on a glass substrate, 500 µm thick with a dimension of 50*50 mm (from Geomatech)) was cleaned for 10 minutes in isopropyl alcohol (IPA) in an ultrasonic cleaner from FNS company, Korea and deionized water) (DI) in an ultrasonic cleaner mean FNS company, Korea. The spin coating conditions were in both cases in a first coating step an acceleration of 5 seconds to a speed of 500 round per minute (RPM). In the second coating step an acceleration of 5 seconds to a speed of 7000 RPM. The leveling was established by putting the coated substrate on a flat table at room temperature for 10 minutes. The spin coated substrates were cooled at room temperature for 5 minutes. After cooling the substrates, they were cured at different temperatures as shown in table 1. A composite with layers of metal-organic compounds/ITO/glass was obtained, which does not comprise first or second silicon.

**Table 1: Materials and conditions of two composites according to the invention**

| **Comp. No.** | **Liquid fluid formulation** | **Viscosity [mPa*s]** | **substrate** | **Liquid fluid volume** | **Curing temperature [°C]** | **Curing time [min]** |
|---|---|---|---|---|---|---|
| 1a | silver neodecanoate (100g in 7ml terpineol) | 9700 | ITO | 6ml | 200 | 30 |
| 2a | silver neodecanoate (300g in 21ml terpineol) | 11000 | ITO | 6ml | 250 | 30 |

For each of the two different composites 1a and 2a, five examples were studied. The results of these studies are summarized in table 2. The results of the resistivities in table 2 were achieved according to the 4 point probe test. The thickness was measured according to the 2D surface profiler as described in the test method section above.

**Table 2: Properties of the two composites listed in table 1**

| **Measurement** | **Composition No 1a** | | | **Composition No 2a** | | |
|---|---|---|---|---|---|---|
| | Thickness [nm] | Sheet resistance [Ω/□] | Resistivity [Ωcm] *10⁻⁶ | Thickness [nm] | Sheet resistance [Ω/□] | Resistivity [Ωcm] *10⁻⁶ |
| 1 | 396 | 0.069 | 2.7 | 450 | 0.070 | 3.2 |
| 2 | 533 | 0.064 | 3.4 | 483 | 0.065 | 3.1 |
| 3 | 2153 | 0.025 | 5.4 | 1072 | 0.030 | 3.2 |
| 4 | 542 | 0.065 | 3.5 | 482 | 0.057 | 2.8 |
| 5 | 464 | 0.070 | 3.3 | 448 | 0.064 | 2.9 |
| Uniformity | 0.156 | 0.044 | 0.127 | 0.037 | 0.100 | 0.066 |

### 2.2. Composite Example 2 - Printing

In a further experiment a printing by applying a gravure offset method was established. Applying of the liquid phase, prepared according to preparation examples 1.1 with components given in table 3, to the ITO glass surface, is established by the gravure offset method. A metal gravure roll was applied at normal pressure, room temperature and 40 to 60 % relative humidity. Further printing conditions are described in table 3. The printing resulted in a grid pattern of lines with different line width also given in table 3.

**Table 3: Conditions for preparation of two composites by off set printing**

| **Composite No.** | **Liquid phase** | **Off speed [mm/sec]** | **Set speed [mm/sec]** | **Off nip [µm]** | **Set nip [µm]** | **Line width [µm]** | **Curing temperature [°C]** |
|---|---|---|---|---|---|---|---|
| 1a | silver neodecanoate (300g in 21ml terpineol) | 50 | 50 | 150 | 80 | 75 | 200 |
| 2a | silver neodecanoate (300g in 21ml terpineol) | 50 | 50 | 150 | 80 | 75 | 250 |

The achieved thicknesses for composite 1a, cured at 200 °C and composite 2a, cured at 250 °C are listed in table 4:

**Table 4: Conditions for preparation of two composites by offset printing**

| **Composite** | **Thickness [nm] before curing** | **Root mean square [nm] before curing** | **Thickness [nm] after curing** | **Root mean square [nm] after curing** |
|---|---|---|---|---|
| 1a | 3092 | 672 | 109 | 19 |
| 2a | 3147 | 672 | 94 | 42 |

By establishing a scanning electron microscopy (SEM) it could be demonstrated that the void and grain size of the composites is increased with increasing curing temperature, comparing the composites No 1a and 2a. It could also be demonstrated that the contact area of the ITO surface to the metal layer, here in form of the silver film can be increased by increasing curing temperature, comparing the SEM results of composite 1a with those of composite 2a. The two composites 1a and 2a also were characterized by an adhesion test. This adhesion test was established according to the description of the SAICAS test in the test method section above. The composite 1a showed a horizontal force of 0.057 kN/m, whereas the composite 2a showed a horizontal force of 0.079 kN/m.

Thus all results of the characterization of the metal layer on the substrate surface show, that the temperature during the curing or heat treatment step, according to step c) of the process according to the invention, has an impact on the adhesion force of the metal layer to the substrate.

### 2.3. Composite Example 3 - Amino Silane Additive

Furthermore, a cross cut test has been established according to the description in the test method above with three different amino silane additive contents of the composition of composite 1a. All other conditions are like those of composite 1a described above. The additional three different composites are named composite No 1', with 0.5 wt.-% amino silane, and composite No 1" with 1.0 wt.-% amino silane and composite No 1"' with 2.0 wt.-% amino silane each based on the weight of the liquid phase. Each composition were diluted to 10 wt.-% silver neodecanoate in terpineol and spin coated by using the above described method on a ITO surface (3000 rpm 20 sec). A composite precursor of diluted composition/ITO/glass was obtained. The precursor was cured at 200°C for 30 minutes.

It has been found that the surface resistance, measured according to the method described in the test method section above, was increased by increasing the amount of amino silane of the liquid phase. Results can be found in table 5.

**Table 5: Composites with amino silane**

| **Composite** | **Surface resistance [Ω/□]** | **Adhesion [cross cut test]** |
|---|---|---|
| 0 (0 wt.-% amino silane) | 0.03 | bad |
| 1' (0.5 wt.-% amino silane) | 0.08 | good |
| 1"(1.0 wt.-% amino silane) | 0,12 | good |
| 1"'(2.0 wt.-% amino silane) | 0.35 | good |

### 2.4. Composite Example 4 - Curing Temperature

In a further example 4, two different silver pastes comprising a silver neodecanoate as metal-organic component is applied to a substrate consisting of glass with an ITO surface are compared as can be seen in Table 6.

**Table 6: Conditions for preparation of two composites by off set printing**

| | | **No. 1** | **No. 2** | **No. 3** | **No. 4** |
|---|---|---|---|---|---|
| **Ag paste** | | Paste 1a | Paste 1a | Paste No. 2 | Paste No. 2 |
| **Average Thickness** | | 141 nm | 136 nm | 142 nm | 124 nm |
| **Curing Process** | | 1^{st} 15 min 200 °C | 1^{st} 30 min 200 °C | 30 min 200 °C | 30 min 250 °C |
| | | 2^{nd} 15 min 250 °C | 2^{nd} 30 min 250 °C | | |
| **Adhesion test** | **Tape test** | bad | good | good | good |
| | **SAICAS test** | 0.058 N/m | 0.079 N/m | 0.104 N/m | 0.076 N/m |

By comparing the results of the composites of table 6, without a first silicon compound, represented by composite No. 1 and 2, with those composites comprising a first silicon compound in form of 3-aminopropyltriethoxy silane it becomes obvious that the adhesion force can be increased by adding a first silicon compound even at lower curing temperature.

### Description of Figures:

- Figure 1:: Schematic view of a multi-layer composite precursor,
- Figure 2:: Scheme of the process for preparing a composite,
- Figure 3:: Schematic view of a multi-layer composite,
- Figure 4:: Schematic view of a gravure printing process to form a composite;
- Figure 5:: Schematic view of an electronic component comprising a multi-layer composite;

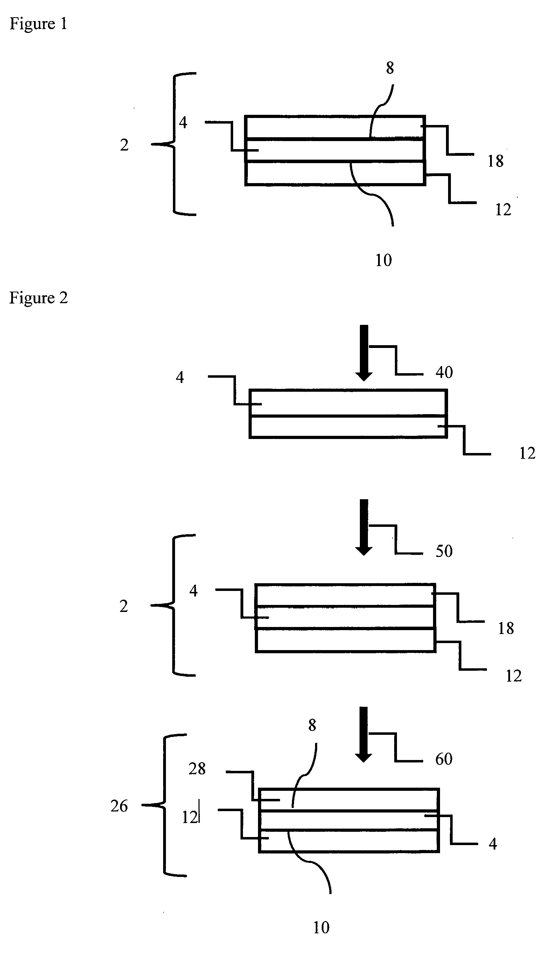

Figure 1 is a schematic view of one embodiment of a multi-layer composite precursor 2 according to the invention. The multi-layer composite 2 comprises a substrate 4 having a first surface 8 and a second surface 10. The first surface 8 is superimposed by a liquid phase 18. The second surface 10 is superimposed by a transparent electrically conducting layer 12.

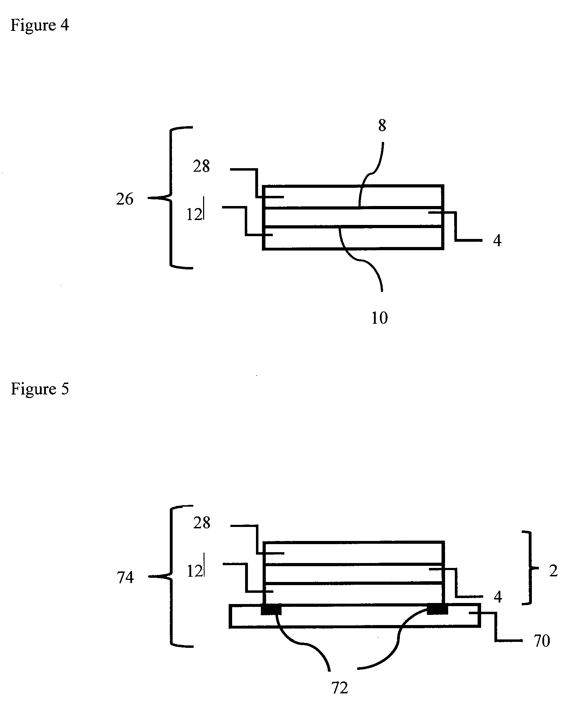

Figure 2 shows a scheme of the process steps for preparing the composite 26 according to the invention. In a first step a) 40 the substrate 4 together with the electrically conducting layer 12 is provided. In this specific example the substrate is a non alkali glass with a thickness of 0.5 mm superimposed by a transparent electrically conducting layer 12 in form of an indium tin oxide (ITO) layer with a thickness of 150 nm. The provision 40 is achieved in this example by uncoiling a roll of the substrate 4 (not shown here). The uncoiled substrate 4 is then fed into a gravure printing machine 32 as shown in figure 4 to apply a liquid phase 18 onto the substrate 4. The liquid phase 18 is composed as described in composition 1a. Details of the printing step b) 50 are shown in figure 4. By this printing step a multi-layer composite precursor 2 according to the invention is achieved. In a further step c) 60, the whole multi-layer precursor 2 is exposed to a surrounding with a temperature of 150 °C for 10 min in a convection oven (Heraeus). By the treatment of the precursor 2 with heat a metal layer 28 is achieved from the liquid phase 18 as the metal-organic component is converted into a metal. In this case a metal layer 28 comprising at least 90 wt.-% silver based on the weight of the metal layer 28 with a thickness of 142 nm is achieved.

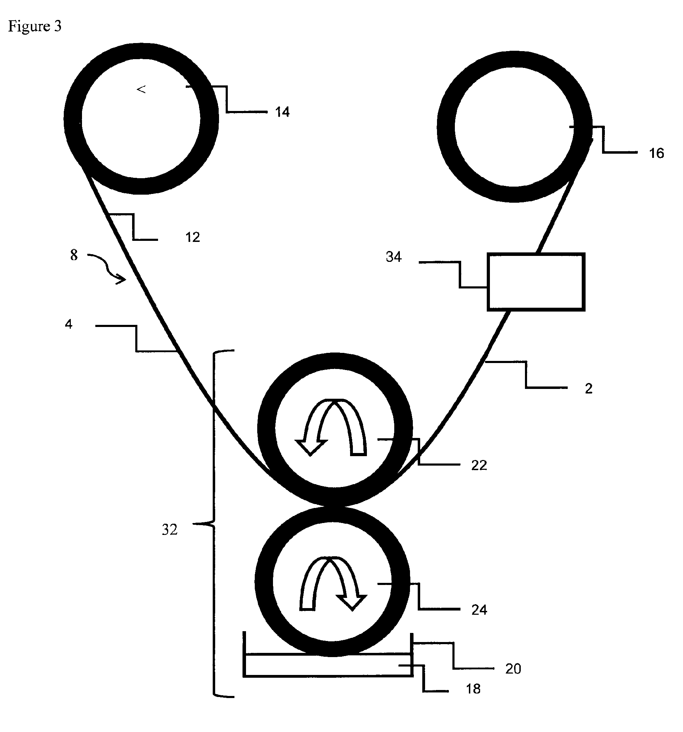

In figure 3 a schematic view of a gravure printing machine 32 is shown, which can be used to prepare a composite precursor 2 according to the invention. In the gravure printing machine 32 the liquid phase 18 is provided in a bath 20. A gravure cylinder 24 in the form of a roll is led through the bath 20 filled with liquid phase 18. The surface of the gravure cylinder 24 comprises a material that sucks a part of the liquid phase 18 into the surface of the cylinder 24. This sucked part of the liquid phase 18 can be transferred to the first surface 8 of the substrate 4 when the substrate 4 is unrolled from the first roll 14 and is brought into contact with the surface of the cylinder 24. An impression roll fixes the substrate 4 to the cylinder 24 in such a way that the substrate 4 is moved between the roll 22 and the cylinder 24 when they are turned in opposite directions to each other. After the contact of the first surface 8 of the substrate 4 with the liquid phase 18 on the cylinder 24 the substrate 4 together with the electrically conducting layer 12 and the liquid phase 18 build a multi-layer composite precursor 2. On the way to the second roll 16 the substrate 4 might be heated in a heating device 34. The heating device 34 can be in the form of an oven or in the form of an irradiation device to reach a temperature in the range of from 100 to 250 °C.

The finished multi-layer composite 26 produced by the process described in figure 3 is shown in figure 4. The multi-layer composite comprises a transparent electrically conducting layer 12 on one side of the substrate 4. On the other side of the substrate 4 a metal layer is arranged. The thickness of the layers (4, 12, 28) are already mentioned for the composite 26 shown in figure 2. The thicknesses of the layers (4, 12, 28) have been determined by the method described above.

The finished multi-layer composite 26 implemented in an electronic component 30 is shown in figure 5. The electronic component 30 can comprise the composite 26 in its interior (not shown) or on its surface as shown in figure 5. The composite 26 according to the invention is connected to the electronic component 70 via electronic contacts 72. Together, the electronic component 70 with the composite 26 and the contacts 72 build an electronic device 74 like a display, for example an OLED display, a touch screen or a transistor.

### List of reference numerals

- 2: multi-layer composite precursor
- 4: substrate
- 8: first surface of substrate
- 10: second surface of substrate
- 12: electrically conducting layer
- 14: first roll
- 16: second roll
- 18: liquid phase
- 20: bath for liquid phase
- 22: impression roll
- 24: gravure cylinder
- 26: composite / multi-layer composite
- 28: metal layer
- 30: electronic component
- 32: gravure printing machine
- 34: heating device
- 40: step a) / provision
- 50: step b) / application
- 60: step c) / treatment
- 70: electronic component
- 72: electronic contacts
- 74: electronic device
- 101: first surface plot
- 102: second surface plot
- 103: third surface plot
- 104: fourth surface plot

## Claims

1. A multi-layer composite precursor (2) comprising:
i. a substrate (4), wherein the substrate (4) comprises
1. a light emitting organic compound
2. a first surface (8), and
3. a second surface (10),
wherein the second surface (10) is superimposed by a transparent electrically conducting layer,
ii. a liquid phase (18) superimposing at least a part of the first surface (8) comprising a metal-organic compound, wherein the metal-organic compound comprises an organic moiety, wherein the organic moiety comprises a C=O group; and wherein the liquid phase (18) further comprises a first silicon compound, wherein the first silicon compound comprises at least one carbon atom and at least one nitrogen atom.

2. The multi-layer composite precursor (2) according to claim 1, wherein the organic moiety of the metal-organic component is selected from the group consisting of a carbonate, an oxalate, an ester, a carboxylate, a halogencarboxylate, a hydroxycarboxylate, an acetonate and a ketonate or mixtures of at least two thereof.

3. The multi-layer composite precursor (2) according to any of the preceding claims, wherein the organic moiety of the metal-organic compound comprises acetylacetonate or neodecanoate or ethylhexanoate or mixtures of at least two thereof.

4. The multi-layer composite precursor (2) according to any of the preceding claims, wherein the first silicon compound is selected from the group consisting of an aminosilane and an aminooxysilane or mixtures of at least two thereof.

5. The multi-layer composite precursor (2) according to any of the preceding claims, wherein the liquid phase (18) further comprises a further silicon compound with at least two silicon atoms, wherein the at least two silicon atoms are connected via one oxygen atom.

6. The multi-layer composite precursor (2) according to claim 5, wherein the further silicon compound is selected from the group consisting of a siloxane and a polysiloxane or mixtures thereof.

7. The multi-layer composite precursor (2) according to any of the preceding claims, wherein the liquid phase (18) comprises the first silicon compound or the further silicon compound or both in a range of from 0.1 to 50 wt.-% based on the total weight of the liquid phase ().

8. The multi-layer composite precursor (2) according to any of the preceding claims, wherein the metal-organic compound is converted into a metal, wherein the converted metal has a content of an organic moiety of less than 10 wt.-% based on the weight of the metal.

9. The multi-layer composite precursor (2) according to any of the preceding claims, wherein the liquid phase (18) further comprises a component selected from the group consisting of
M1. an organic compound selected from the group consisting of an alcohol, an organic acid, an amine, a diamine an ester, an ether, a ketone, a silicone, a sulfonate and a polymer or mixtures of at least two thereof;
M2. an inorganic compound selected from the group consisting of water, a silane, an inorganic ester, a ceramic, a glass, a polymer and a metal or mixtures of at least two thereof;
or mixtures thereof.

10. The multi-layer composite precursor (2) according to any of the preceding claims, wherein the metal-organic compound comprises a metal selected from the group consisting of silver, gold, platinum and palladium or at least two thereof.

11. The multi-layer composite precursor (2) according to any of the preceding claims, wherein the metal-organic compound comprises silver.

12. The multi-layer composite precursor (2) according to any of the preceding claims, wherein the liquid phase (18) has a thickness in a range of from 0.1 to 5000 µm.

13. The multi-layer composite precursor (2) according to any of the preceding claims, wherein the liquid phase (18) has a viscosity in a range of from 100 to 50000 mPa*s.

14. The multi-layer composite precursor (2) according to any of the preceding claims, wherein the substrate (4) comprises a component selected from the group consisting of a ceramic, a polymer, a glass and a metal or a combination thereof.

15. A process for preparing a composite (26) comprising the steps of:
a) providing a substrate (4), wherein the substrate (4) comprises
1. a light emitting organic compound,
2. a first surface (8), and
3. a second surface (10),
wherein the second surface (10) is superimposed by a transparent electrically conducting layer (12),
b) applying a liquid phase (18) onto at least a part of the first surface (8) in order to obtain a composite precursor (2), wherein the liquid phase (18) comprises a metal-organic compound and wherein the liquid phase (18) further comprises a first silicon compound, wherein the silicon compound comprises at least one carbon atom and at least one nitrogen atom,
c) treating the composite precursor (2) at a temperature in a range from 100 to 250°C, in order to obtain the composite (26);
wherein the metal-organic compound comprises an organic moiety, wherein the organic moiety comprises a C=O group.

16. The process according to claim 15, wherein the organic moiety of the metal-organic component is selected from the group consisting of a carbonate, an oxalate, an ester, a carboxylate, a halogencarboxylate, a hydroxycarboxylate, an acetonate and a ketonate or mixtures of at least two thereof.

17. The process according to claims 15 or 16, wherein the organic moiety of the metal-organic compound comprises acetylacetonate or neodecanoate or ethylhexanoate, or mixtures of at least two of them.

18. The process according to any of claims 15 to 17, wherein the first silicon compound is selected from the group consisting of an aminosilane and an aminooxysilane or mixtures of at least two thereof.

19. The process according to any of claims 15 to 18, wherein the liquid phase (18) comprises a further silicon compound with at least two silicon atoms, wherein the at least two silicon atoms are connected via one oxygen atom.

20. The process according to claim 19, wherein the further silicon compound is selected from the group consisting of a siloxane or a polysiloxane or mixtures thereof.

21. The process according to any of claims 15 to 20, wherein the first silicon compound or the further silicon compound or both are comprised in the liquid phase (18) in a range of from 0.1 to 50 wt.-% based on the weight of the liquid phase (18).

22. The process according to any of claims 15 to 21, wherein the metal-organic compound is converted into a metal, wherein the converted metal has a content of an organic moiety of less than 10 wt.-% based on the weight of the metal.

23. The process according to any of claims 15 to 22, wherein the liquid phase (18) further comprises a component selected from the group consisting of
M1. an organic compound selected from the group consisting of an alcohol, an organic acid, an amine, a diamine an ester, an ether, a ketone, a silicone, a sulfonate and a polymer or mixtures of at least two thereof;
M2. an inorganic compound selected from the group consisting of water, a silane, an inorganic ester, a ceramic, a glass, a polymer and a metal or mixtures of at least two thereof;
or mixtures thereof.

24. The process according to any of claims 15 to 23, wherein the metal-organic compound comprises a metal selected from the group consisting of silver, gold, platinum and palladium or at least two thereof.

25. The process according to any of claims 154 to 24, wherein the metal-organic compound comprises silver.

26. The process according to any of claims 15 to 25, wherein the composite (26) comprises a metal layer (28), wherein the metal layer (28) has a thickness in a range of from 0.01 to 10 µm after step (c).

27. The process according to any of claims 15 to 26, wherein the liquid phase (18) has a viscosity in a range of from 100 to 50000 mPa*s.

28. The process according to any of claims 15 to 27, wherein the substrate (4) comprises a component selected from the group consisting of a ceramic, a polymer, a glass and a metal or a combination of at least two thereof.

29. A composite (26) obtainable according to any of claims 15 to 28.

30. A multi-layer composite (26) comprising:
i. a substrate (4), and
ii. a metal layer (28);
wherein the metal layer (28) has at least one of the following properties:
P1. a surface roughness in a range of 0.1 nm to 1000 nm ;
P2. a resistivity in a range of 1 x 10⁻⁶ Ω cm to 1 x 10⁻³ Ω·cm;
P3. a crystal-size in a range of 1 nm to 10 µm; or
P4. a thickness in a range of from 0.001 to 50 µm.

31. An electronic component (30) comprising a composite (26) according to claims 29 or 30.

32. The electronic component (30) of claim 31 is selected from the group consisting of an OLED, a transistor and a touch screen.
